(19) 
**Europäisches Patentamt**
**European Patent Office**
**Office européen des brevets**

(11) **EP 4 249 932 A1**

(12) 
# EUROPEAN PATENT APPLICATION
published in accordance with Art. 153(4) EPC

(43) Date of publication:
**27.09.2023 Bulletin 2023/39**

(21) Application number: **21906450.8**

(22) Date of filing: **07.12.2021**

(51) International Patent Classification (IPC):
**G01R 31/52** *(2020.01)*       **G01R 31/58** *(2020.01)*

(52) Cooperative Patent Classification (CPC):
**G01R 31/52; G01R 31/58**

(86) International application number:
**PCT/JP2021/045001**

(87) International publication number:
**WO 2022/131087 (23.06.2022 Gazette 2022/25)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority:  **14.12.2020  JP 2020207148**

(71) Applicant: **So Brain Co., Ltd.
Tokyo, 101-0064 (JP)**

(72) Inventor: **KASHIRAMOTO Yorikazu
Tokyo 101-0064 (JP)**

(74) Representative: **Fédit-Loriot
22, rue du Général Foy
75008 Paris (FR)**

(54)    **INSPECTION DEVICE, INSPECTION METHOD, AND INSPECTION PROGRAM**

(57)    An inspection device includes: a leakage current detector 11 configured to detect a leakage current flowing through star-connected line wires to be measured; a voltage detector 12 configured to detect a voltage applied to the line wires to be measured; a phase angle detector 13 configured to detect a phase angle based on the leakage current detected by the leakage current detector 11 and the voltage detected by the voltage detector 12; a determiner 14 configured to determine to which one of first, second, and third angle ranges the phase angle detected by the phase angle detector 13 belongs; and a calculator 15 configured to calculate a resistive component leakage current due to a ground insulation resistance included in the leakage current flowing through the line wire to be measured, based on the angle range to which the phase angle belongs, the phase angle detected by the phase angle detector 13, and the leakage current detected by the leakage current detector 11.

FIG.1

EP 4 249 932 A1

## Description

TECHNICAL FIELD

The present disclosure relates to an inspection device, an inspection method, and an inspection program for inspecting or monitoring an insulation resistance value and a leakage current value of a three-phase, star connection line wires.

BACKGROUND ART

The insulation performance of an electrical system including a load device of electrical equipment is very important to prevent electric shocks, fires, or the like. The insulation performance is, however, degraded by aging of the electrical equipment, works, or other factors, which may cause a leakage current (hereinafter referred to as "Io") in a line wire. It is important to predict the occurrence of Io or detect an actually occurring Io so that accidents be prevented in advance or at an early stage.

For this purpose, an inspection device for inspecting Io is provided for a voltage transformer, on the ground wire of a secondary circuit. Here, Io includes a leakage current caused by a ground capacitance (hereinafter referred to as "Ioc"), and a leakage current caused by a ground insulation resistance directly related to an insulation resistance (hereinafter referred to as "Ior").

For example, Patent Document 1 discloses a device for measuring leakage currents Ior caused by insulation resistances of any two distribution lines of a three-phase, three-wire star-connected system. The device includes: a voltage detector configured to detect a line voltage between the two distribution lines; a current detector configured to detect a combined current of the currents flowing through the two distribution lines; and a processor configured to calculate a phase angle θ between the line voltage and the combined current and a current value Io of the combined current and measure the leakage current Ior based on the following equation:

$$\text{Ior} = |2 \times \text{Io} \times \sin\theta|$$

CITATION LIST

PATENT DOCUMENT

Patent Document 1: Japanese Unexamined Patent Publication No. 2011-27449

SUMMARY OF THE INVENTION

TECHNICAL PROBLEMS

If an insulation resistance deteriorates in any two distribution lines of the three-phase, three-wire star-connected system, Ior is represented by the scalar sum of the two phases. However, it is difficult to specify the problematic point of Ior (where Ior occurs) and grasp the cause of the Ior and changes detected in periodic inspections, without knowing the ratio of occurrence of the Ior in the two phases.

It is an objective of the present disclosure to provide an inspection device, an inspection method, and an inspection program that enable, in the event of the occurrence of Ior in one or both of two phases, accurate calculation of Ior occurring in each phase, thereby making it possible to inspect or monitor star-connected line wires to be measured.

SOLUTION TO THE PROBLEMS

In order to achieve the objective, the present disclosure provides the following configurations.

(1) An inspection device including: a leakage current detector configured to detect a leakage current flowing through line wires to be measured in which a first phase, a second phase, and a third phase are star-connected or the first phase, the second phase, the third phase, and a neutral wire are star-connected; a voltage detector configured to detect a voltage applied to the line wires to be measured; a phase angle detector configured to detect a phase angle, based on the leakage current detected by the leakage current detector and the voltage detected by the voltage detector; a determiner configured to determine to which one of a first angle range, a second angle range, and a third angle range the phase angle detected by the phase angle detector belongs, the first angle range being an angle range between the first phase and the second phase, the second angle range being an angle range between the second phase and the third phase, the third angle range being an angle range between the third phase and the first phase; and a calculator configured to calculate a resistive component leakage current due to a ground insulation resistance included in the leakage current flowing through the line wires to be measured, based on the angle range to which the phase angle belongs, the phase angle detected by the phase angle detector, and the leakage current detected by the leakage current detector.

(2) The inspection device of (1), wherein the calculator calculates: a combined value of the resistive component leakage currents flowing in the first phase and the second phase and the resistive component leakage current flowing in each of the first phase and the second phase, if the phase angle belongs to the first angle range; a combined value of the resistive component leakage currents flowing in the second phase and the third phase and the resistive component leakage current flowing in each of the second phase and the third phase, if the phase angle belongs to the second angle range; and a combined value of the resistive component leakage currents flowing in the first phase and the third phase and the resistive component leakage current flowing in each of the first phase and the third phase, if the phase angle belongs to the third angle range.

(3) The inspection device of (1) or (2), wherein using a voltage of the first phase as a reference, the first angle range is an angle range of 120° between the first phase and the second phase, the second angle range is an angle range of 120° between the second phase and the third phase, and the third angle range is an angle range of 120° between the third phase and the first phase.

(4) The inspection device of any one of (1) to (3) wherein the voltage detector detects a line voltage between any two of three non-ground wires, a voltage between each of any two phases and a ground wire or the neutral wire, a voltage between any one of the three non-ground wires and the ground wire or the neutral wire, or a voltage between each of all the three non-ground wires and the ground wire or the neutral wire, or between the ground wire and each of all the wires including the neutral wire.

(5) An inspection method including: detecting a leakage current flowing through line wires to be measured in which a first phase, a second phase, and a third phase are star-connected or the first phase, the second phase, the third phase, and a neutral wire are star-connected; detecting a voltage applied to the line wires to be measured; detecting a phase angle, based on the leakage current detected in the detecting the leakage current and the voltage detected in the detecting the voltage; determining to which one of a first angle range, a second angle range, and a third angle range the phase angle detected in the detecting the phase angle belongs, the first angle range being an angle range between the first phase and the second phase, the second angle range being an angle range between the second phase and the third phase, the third angle range being an angle range between the third phase and the first phase; and calculating a resistive component leakage current due to a ground insulation resistance included in the leakage current flowing through the line wires to be measured, based on the angle range to which the phase angle belongs, the phase angle detected in the detecting the phase angle, and the leakage current detected in the detecting the leakage current.

(6) An inspection program for causing a computer to execute: detecting a leakage current flowing through line wires to be measured in which a first phase, a second phase, and a third phase are star-connected or the first phase, the second phase, the third phase, and a neutral wire are star-connected; detecting a voltage applied to the line wires to be measured; detecting a phase angle, based on the leakage current detected in the detecting the leakage current and the voltage detected in the detecting the voltage; determining to which one of a first angle range, a second angle range, and a third angle range the phase angle detected in the detecting the phase angle belongs, the first angle range being an angle range between the first phase and the second phase, the second angle range being an angle range between the second phase and the third phase, the third angle range being an angle range between the third phase and the first phase; and calculating a resistive component leakage current due to a ground insulation resistance included in the leakage current flowing through the line wires to be measured, based on the angle range to which the phase angle belongs, the phase angle detected in the detecting the phase angle, and the leakage current detected in the detecting the leakage current.

ADVANTAGES OF THE INVENTION

The present disclosure enables, in the event of the occurrence of Ior in one or both of two phases, accurate calculation of Ior occurring in each phase, thereby making it possible to inspect or monitor star-connected line wires to be measured.

BRIEF DESCRIPTION OF THE DRAWINGS

FIG. 1 is a diagram illustrating a configuration of an inspection device.
FIG. 2 is a diagram schematically illustrating angle ranges.
FIG. 3 is a diagram for explaining vector representations of a leakage current caused by a ground capacitance and a leakage current caused by a ground insulation resistance.
FIG. 4 is a diagram schematically illustrating the scalar sum of Ior(r) and Ior(t).
FIG. 5 is a diagram schematically illustrating a case where a phase angle belongs to a first angle range R1.
FIG. 6 is a diagram schematically illustrating a case where the phase angle belongs to a second angle range R2.
FIG. 7 is a diagram schematically illustrating a case where the phase angle belongs to a third angle range R3.
FIG. 8 is a flowchart for explaining a procedure of an inspection method.
FIG. 9 is a block diagram illustrating a first configuration example of a computer.
FIG. 10 is a block diagram illustrating a second configuration example of a computer.

DESCRIPTION OF EMBODIMENT

Embodiments of the present disclosure will be described below. The embodiments described below do not unreasonably limit the contents of the present disclosure recited in the appended claims. Not all the configurations described in the embodiments are essential constituent elements of the present disclosure.

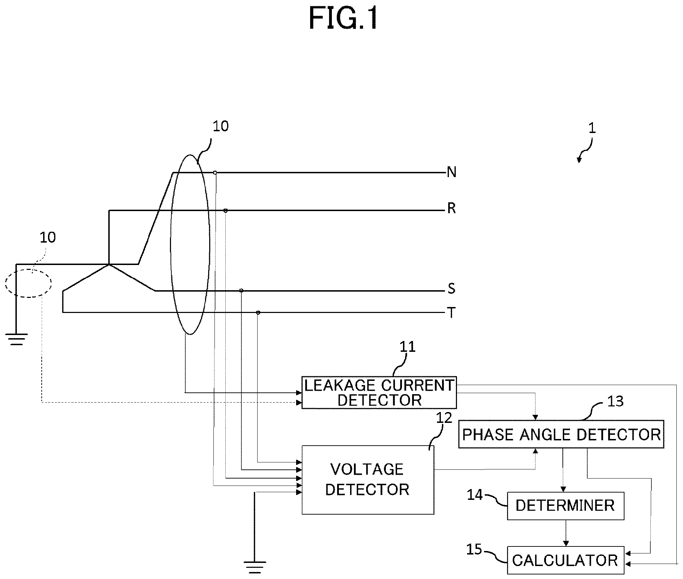

FIG. 1 is a diagram illustrating a configuration of an inspection device 1. The inspection device 1 includes a leakage current detector 11, a voltage detector 12, a phase angle (phase) detector 13, a determiner 14, and a calculator 15.

The leakage current detector 11 detects a leakage current flowing through line wires to be measured in which first, second, and third phases are star-connected (or Y-connected). While the first, second, and third phases are hereinafter referred to as "R-phase," "T-phase," and "S-phase," respectively, the names are not limited thereto. While a leakage current measured by the leakage current detector 11 is hereinafter referred to as "Io," the name is not limited thereto.

While an example will be described in which the inspection device 1 inspects or monitors line wires to be measured of a three-phase, four-wire system where three phases (R-, S-, and T-phases) are star-connected and the neutral point is drawn out, the configuration is not limited thereto. The inspection device 1 may inspect or monitor line wires to be measured of a three-phase, three-wire system where three phases (R-, S-, and T-phases) are star-connected without the neutral wire.

A zero-phase current transformer (ZCT) 10 is connected to the leakage current detector 11. The zero-phase current transformer 10 is configured to clamp the line wires collectively. For example, the zero-phase current transformer 10 may be configured as a handy-type split-core zero-phase current transformer, which makes it possible for an operator to easily place the current transformer to the line wires on site. The zero-phase current transformer 10 may also clamp a Class B ground wire as indicated by the dashed line in FIG. 1.

The leakage current detector 11 detects (calculates) a leakage current (Io) flowing through the line wires to be measured, from a signal measured by the zero-phase current transformer 10.

The voltage detector 12 detects a voltage applied to the respective line wires to be measured. The line wires to be measured may have various configurations. Accordingly, there are some possible configurations of the voltage detector 12 for detecting the voltage. For example, the following configurations are conceivable as the configurations of the voltage detector 12 for detecting the voltage. In the present disclosure, a suitable configuration is employed as appropriate in accordance with the configuration of the line wires to be actually inspected or monitored. The configuration of the voltage detector 12 for detecting a voltage is not limited to the following configurations.

Configuration 1: Configuration for detecting a line voltage between any two of three non-ground wires

Configuration 2: Configuration for detecting a voltage between each of any two phases and the ground wire or the neutral wire

Configuration 3: Configuration for detecting a voltage between any one of the three non-ground wires and the ground wire or the neutral wire

Configuration 4: Configuration for detecting a voltage between each of all the three non-ground wires and the ground wire (Class D ground wire) or the neutral wire, or between the ground wire (Class D ground wire) and each of all the wires including the neutral wire

The phase angle detector 13 detects a phase angle ($\theta$) based on the leakage current (Io) detected by the leakage current detector 11 and the voltage detected by the voltage detector 12. Specifically, the phase angle detector 13 detects the phase angle ($\theta$) through arithmetic processing of the waveform of the leakage current (Io) detected by the leakage current detector 11 and the waveform of the voltage detected by the voltage detector 12 (e.g., the line voltage ($V_{T-R}$) between the R-phase and the T-phase is regarded as a reference voltage). For example, the phase angle detector 13 detects the phase angle ($\theta$) between the reference voltage ($V_{T-R}$) and the leakage current (Io) based on the zero-crossing point of the reference voltage ($V_{T-R}$) and the zero-crossing point of the leakage current (Io). The arithmetic processing for calculating the phase angle may be performed by synchronous detection or discrete Fourier transform (DFT).

The determiner 14 determines to which one of first, second, and third angle ranges R1, R2, and R3 the phase angle detected by the phase angle detector 13 belongs. The first angle range R1 is an angle range between the R-phase and T-phase. The second angle range R2 is an angle range between the T-phase and S-phase. The third angle range R3 is an angle range between the S-phase and R-phase.

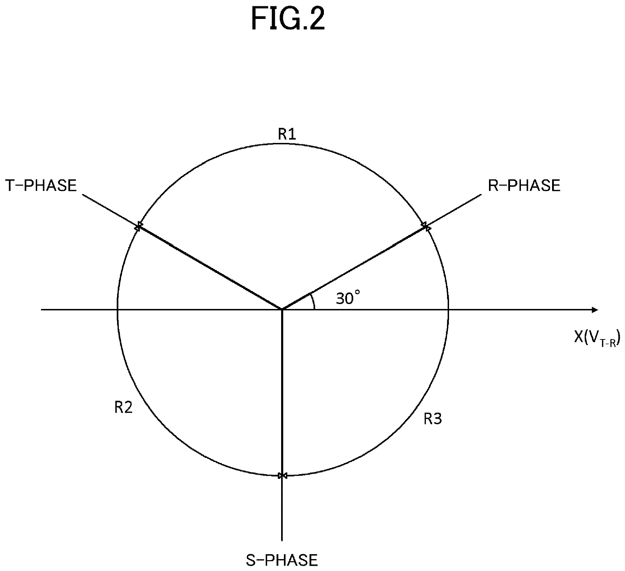

FIG. 2 is a diagram schematically illustrating the angle ranges. Here, using the voltage of the R-phase as a reference, the first angle range R1 is an angle range of 120° between the R-phase and T-phase, the second angle range R2 is an angle range of 120° between the T-phase and S-phase, and the third angle range R3 is an angle range of 120° between the S-phase and R-phase. Specifically, assume that the line voltage ($V_{T-R}$) between the R-phase and the T-phase is set as a reference voltage and this voltage is regarded as 0°, and that a current flowing through the R-phase occurs at a direction of 30°. In this case, the first angle range R1 is "30° $\leq \theta <$ 150°," the second angle range R2 is "150° $\leq \theta <$ 270°," and the third angle range R3 is "270° $\leq \theta <$ 30°." The angle ranges can be generalized as follows: if a voltage of the R-phase occurs at a direction of X°, the first angle range R1 is "X° $\leq \theta <$ (X° + 120°)," the second angle range R2 is "(X° + 120°) $\leq \theta <$ (X° + 240°)," and the third angle range R3 is "(X° + 240°) $\leq \theta <$ X°."

The calculator 15 calculates a resistive component leakage current due to the ground insulation resistance included in the leakage current flowing through the line wire to be measured, based on the angle range to which the phase angle belongs, the phase angle detected by the phase angle detector 13, and the leakage current detected by the leakage current detector 11.

Specifically, if the phase angle detected by the phase angle detector 13 belongs to the first angle range R1, the calculator 15 calculates the combined value of the resistive component leakage currents flowing in the R-phase and T-phase and the resistive component leakage current flowing in each of the phases. If the phase angle detected by the phase angle detector 13 belongs to the second angle range R2, the calculator 15 calculates the combined value of the resistive component leakage currents flowing in the T-phase and S-phase and the resistive component leakage current flowing in each of the phases. If the phase angle detected by the phase angle detector 13 belongs to the third angle range R3, the calculator 15 calculates the combined value of the resistive component leakage currents flowing in the S-phase and R-phase and the resistive component leakage current flowing in each of the phases.

In this manner, the inspection device 1 calculates the combined value of Ior flowing in the phases and Ior flowing in each of the phases, based on the angle range to which the phase angle (i.e., phase difference) detected by the phase angle detector 13 belongs. Thus, the inspection device 1 can accurately calculate, in the event of the occurrence of Ior in one or both of two phases, Ior occurring in each phase, thereby making it possible to inspect or monitor the star-connected line wires to be measured.

(Vector Representations of Io, Ioc, and Ior)

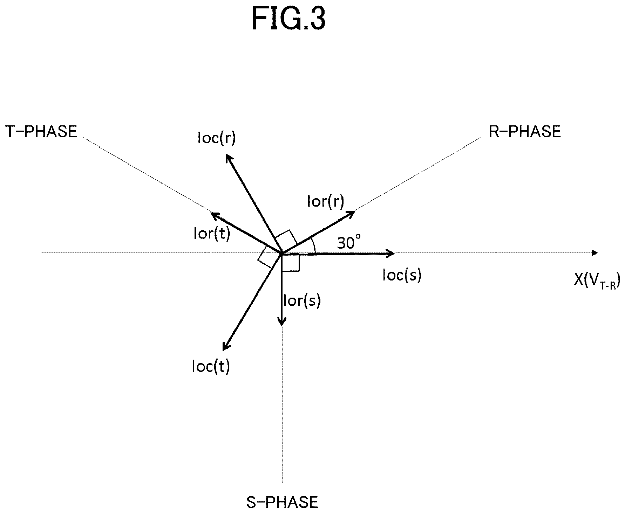

Now, vector representations of a leakage current caused by a ground capacitance (hereinafter may be referred to as "Ioc") included in a leakage current (Io) and a leakage current caused by a ground insulation resistance (hereinafter may be referred to as "Ior") directly related to an insulation resistance will be described with reference to FIG. 3. FIG. 3 is a diagram schematically illustrating vector representations of Ior and Ioc of each phase.

Assume that a reference voltage is 0° and that a resistive component leakage current flowing through the R-phase (hereinafter may be referred to as "Ior(r)") occurs at a direction of 30° in vector representation. In this case, a resistive component leakage current flowing in the T-phase (hereinafter may be referred to as "Ior(t)") occurs at a direction of 150°, and a resistive component leakage current flowing in the S-phase (hereinafter may be referred to as "Ior(s)") occurs at a direction of 270°. In the following description, the vector Ior(r) will be simply referred to as "Ior(r)," the vector Ior(t) simply as "Ior(t)," and the vector Ior(s) simply as "Ior(s)." In this example, the line voltage between the R-phase and the T-phase is regarded as the reference voltage, which is set to 0°.

A capacitive component leakage current flowing in the R-phase (hereinafter may be referred to as "Ioc(r)") occurs at a direction of 120° which is advanced from Ior(r) by 90° ($\pi/2$). A capacitive component leakage current flowing in the T-phase (hereinafter may be referred to as "Ioc(t)") occurs at a direction of 240° which is advanced from Ior(t) by 90° ($\pi/2$). A capacitive component leakage current flowing in the S-phase (hereinafter may be referred to as "Ioc(s)") occurs at a direction of 0° (i.e., 360°) which is advanced from Ior(s) by 90° ($\pi/2$).

In the following description, the vector Ioc(r) will be simply referred to as "Ioc(r)," the vector Ioc(t) simply as "Ioc(t)," and the vector Ioc(s) simply as "Ioc(s)."

If Ioc(r), Ioc(s), and Ioc(t) are balanced, the vector Ioc which is a combination of Ioc(r), Ioc(s), and Ioc(t) does not appear by being canceled by the respective components.

Next, the combination (i.e., the scalar sum) of Ior occurring in two phases (e.g., the R-phase and the T-phase) will be described.

Ior is calculated by substituting the phase angle θ detected by the phase angle detector 13 and the leakage current Io detected by the leakage current detector 11 into Equation (1).

$$\mathrm{Ior} = \mathrm{Io} \times \sin\theta/\cos 60° \ . \ . \ . \ (1)$$

Ior obtained by Equation (1) corresponds to the scalar sum (Ior(r) + Ior(t)).

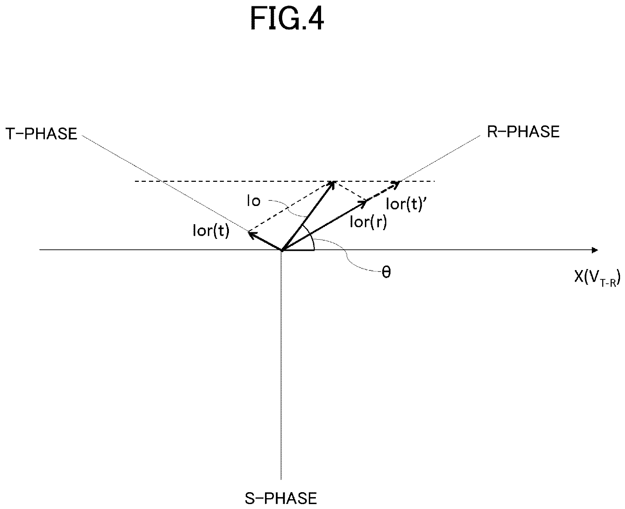

FIG. 4 is a diagram schematically illustrating the scalar sum of Ior(r) and Ior(t). FIG. 4 assumes that Ioc(r), Ioc(t), and Ioc(s) are in a balanced state and therefore that they cancel each other. In FIG. 4, Ior(t) is moved to the R-phase axis (Ior(t) after the movement is represented by Ior(t)') and combined with Ior(r) (into the scalar sum: Ior(r) + Ior(t)').

Since Ior obtained by Equation (1) is the combination (i.e., the scalar sum) of two phases, it is impossible to know from the combination itself whether the leakage current caused by the ground insulation resistance occurs only in the R-phase, only in the T-phase, or in both the R-phase and T-phase. Accordingly, the inspection device 1 calculates the combined value of Ior flowing in the phases and Ior flowing in each phase, based on the angle range to which the phase angle (i.e., phase) detected by the phase angle detector 13 belongs.

(Case where Phase Angle Belongs to First Angle Range R1)

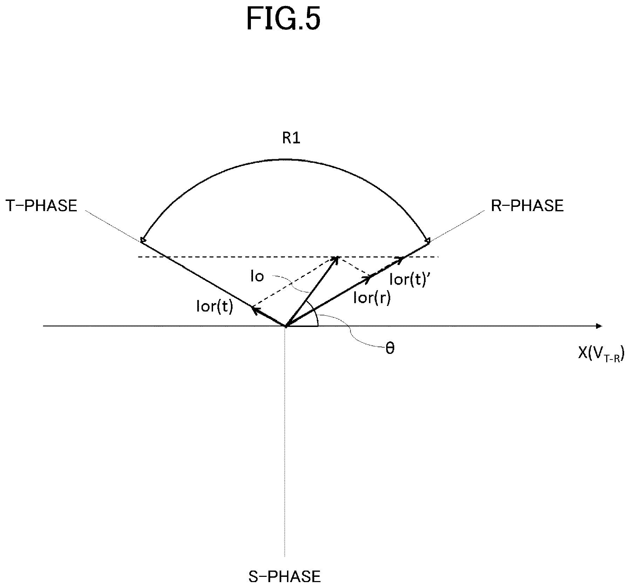

FIG. 5 is a diagram schematically illustrating a case where the phase angle belongs to the first angle range R1. If the phase angle belongs to the first angle range R1, the calculator 15 calculates the combination (i.e., the scalar sum: Ior(rt)) of Ior occurring in two phases (i.e., R-phase and T-phase) by substituting the phase angle θ detected by the phase angle detector 13 and the leakage current Io detected by the leakage current detector 11 into Equation (2).

$$Ior(rt) = Io \times \sin\theta/\cos 60° \ . \ . \ . \ (2)$$

The calculator 15 calculates Ior(r) occurring in the R-phase by substituting the phase angle θ detected by the phase angle detector 13 and the leakage current Io detected by the leakage current detector 11 into Equation (3).

$$Ior(r) = Io \times \sin(150° - \theta)/\cos 30° \ . \ . \ . \ (3)$$

The calculator 15 calculates Ior(t) occurring in the T-phase by substituting Ior(rt) obtained by Equation (2) and Ior(r) obtained by Equation (3) into Equation (4).

$$Ior(t) = Ior(rt) - Ior(r) \ . \ . \ . \ (4)$$

For example, if Ior(t) is "0," it means "Ior(rt) = Ior(r)," from which it is known that the leakage current caused by the ground insulation resistance is flowing only in the R-phase. On the other hand, if Ior(r) is "0," it means "Ior(rt) = Ior(t)," from which it is known that the leakage current caused by the ground insulation resistance is flowing only in the T-phase. If Ior(t) and Ior(r) are other than "0," it means that the leakage current caused by the ground insulation resistance is flowing in both the R-phase and T-phase, and it is possible to calculate quantitatively how much leakage current caused by the ground insulation resistance is flowing in the R-phase and T-phase by utilizing Equations (3) and (4).

(Case where Phase Angle Belongs to Second Angle Range R2)

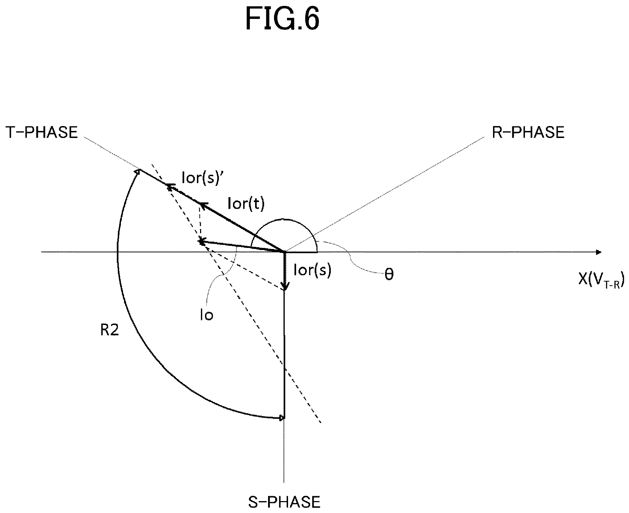

FIG. 6 is a diagram schematically illustrating a case where the phase angle belongs to the second angle range R2. In FIG. 6, Ior(s) is moved to the T-phase axis (Ior(s) after the movement is represented by Ior(s)') and combined with Ior(t) (into the scalar sum: Ior(t) + Ior(s)').
If the phase angle belongs to the second angle range R2, the calculator 15 calculates the combination (i.e., the scalar sum: Ior(ts)) of Ior occurring in two phases (i.e., T-phase and S-phase) by substituting the phase angle θ detected by the phase angle detector 13 and the leakage current Io detected by the leakage current detector 11 into Equation (5).

$$Ior(ts) = Io \times \sin(\theta - 120°)/\cos 60° \ . \ . \ . \ (5)$$

The calculator 15 calculates Ior(t) occurring in the T-phase by substituting the phase angle θ detected by the phase angle detector 13 and the leakage current Io detected by the leakage current detector 11 into Equation (6).

$$Ior(t) = Io \times \sin(270° - \theta)/\cos 30° \ . \ . \ . \ (6)$$

The calculator 15 calculates Ior(s) occurring in the S-phase by substituting Ior(ts) obtained by Equation (5) and Ior(t) obtained by Equation (6) into Equation (7).

$$Ior(s) = Ior(ts) - Ior(t) \ . \ . \ . \ (7)$$

For example, if Ior(s) is "0," it means "Ior(ts) = Ior(t)," from which it is known that the leakage current caused by the ground insulation resistance is flowing only in the T-phase. On the other hand, if Ior(t) is "0," it means "Ior(ts) = Ior(s)," from which it is known that the leakage current caused by the ground insulation resistance is flowing only in the S-phase. If Ior(s) and Ior(t) are other than "0," it means that the leakage current caused by the ground insulation resistance is flowing in both the S-phase and T-phase, and it is possible to calculate quantitatively how much leakage current caused by the ground insulation resistance is flowing in the T-phase and S-phase by utilizing Equations (6) and (7).

(Case where Phase Angle Belongs to Third Angle Range R3)

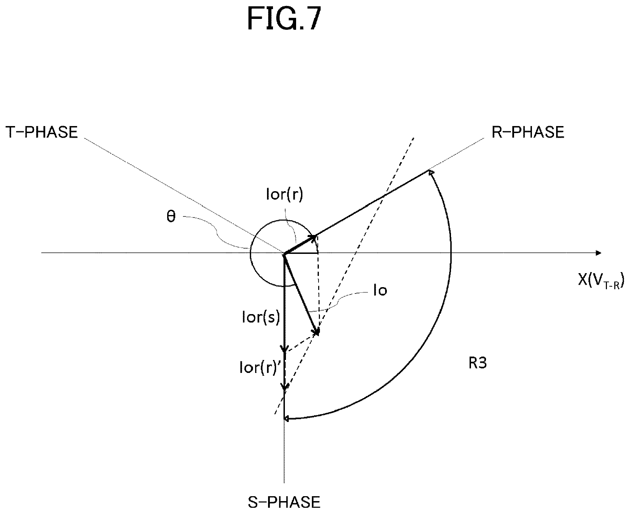

FIG. 7 is a diagram schematically illustrating a case where the phase angle belongs to the third angle range R3. In FIG. 7, Ior(r) is moved to the S-phase axis (Ior(r) after the movement is represented by Ior(r)') and combined with Ior(s) (into the scalar sum: Ior(s) + Ior(r)').
If the phase angle belongs to the third angle range R3, the calculator 15 calculates the combination (i.e., the scalar sum: Ior(sr)) of Ior occurring in two phases (i.e., S-phase and R-phase) by substituting the phase angle θ detected by the phase angle detector 13 and the leakage current Io detected by the leakage current detector 11 into Equation (8).

$$Ior(sr) = Io \times \sin(\theta - 240°)/\cos 60° \ . \ . \ . \ (8)$$

The calculator 15 calculates Ior(s) occurring in the S-phase by substituting the phase angle θ detected by the phase angle detector 13 and the leakage current Io detected by the leakage current detector 11 into Equation (9).

$$Ior(s) = Io \times \sin(30° - \theta)/\cos 30° \ . \ . \ . \ (9)$$

The calculator 15 calculates Ior(r) occurring in the R-phase by substituting Ior(sr) obtained by Equation (8) and Ior(s) obtained by Equation (9) into Equation (10).

$$Ior(r) = Ior(sr) - Ior(s) \quad . \quad . \quad . \quad (10)$$

For example, if Ior(r) is "0," it means "Ior(sr) = Ior(s)," from which it is known that the leakage current caused by the ground insulation resistance is flowing only in the S-phase. On the other hand, if Ior(s) is "0," it means "Ior(sr) = Ior(r)," from which it is known that the leakage current caused by the ground insulation resistance is flowing only in the R-phase. If Ior(r) and Ior(s) are other than "0," it means that the leakage current caused by the ground insulation resistance is flowing in both the R-phase and S-phase, and it is possible to calculate quantitatively how much leakage current caused by the ground insulation resistance is flowing in the S-phase and R-phase by utilizing Equations (9) and (10).

In this manner, the inspection device 1 enables accurate calculation of Ior occurring in R-phase and T-phase by utilizing Equations (2), (3), and (4) if the angle range of the phase angle belongs to the first angle range R1, accurate calculation of Ior occurring in T-phase and S-phase by utilizing Equations (5), (6), and (7) if the angle range of the phase angle belongs to the second angle range R2, and accurate calculation of Ior occurring in S-phase and R-phase by utilizing Equations (8), (9), and (10) if the angle range of the phase angle belongs to the third angle range R3. Based on these Ior calculated, it is possible to inspect or monitor the star-connected line wires to be measured.

(Inspection Method)

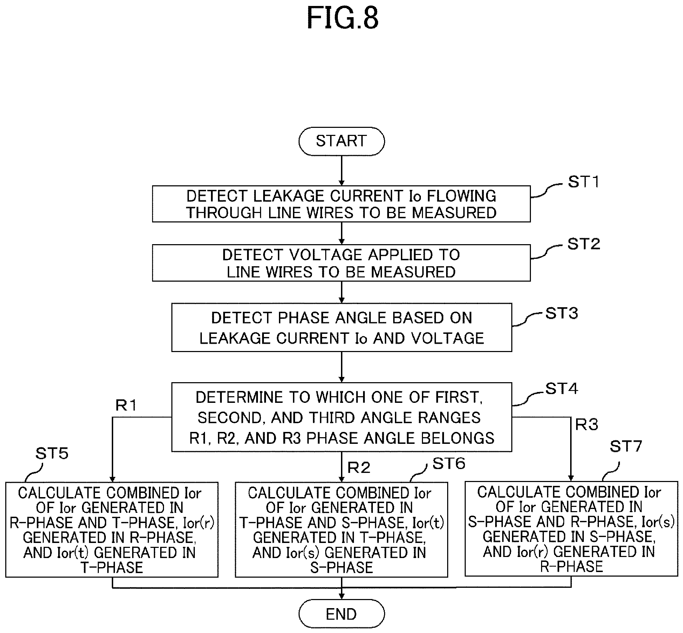

Here, an inspection method using the inspection device 1 will be described. FIG. 8 is a flowchart for explaining a procedure of the inspection method.

In step ST1, the leakage current detector 11 detects a leakage current flowing through line wires to be measured in which R-, S-, and T-phases are star-connected (leakage current detection step).

In step ST2, the voltage detector 12 detects a voltage applied to the line wires to be measured (voltage detection step).

In step ST3, the phase angle detector 13 detects a phase angle (phase angle detection step), based on the leakage current detected in the leakage current detection step and the voltage detected in the voltage detection step.

In step ST4, the determiner 14 determines to which one of first, second, and third angle ranges R1, R2, and R3 the phase angle detected in the phase angle detection step belongs (determination step). The first angle range R1 is an angle range between the first and second phases. The second angle range R2 is an angle range between the second and third phases. The third angle range R3 is an angle range between the third and first phases. If the phase angle is in the first angle range R1, the process proceeds to step ST5. If the phase angle is in the second angle range R2, the process proceeds to step ST6. If the phase angle is in the third angle range R3, the process proceeds to step ST7.

In step ST5, the calculator 15 calculates a resistive component leakage current due to the ground insulation resistance included in the leakage current flowing through the line wire to be measured, based on the phase angle detected in the phase angle detection step and the leakage current detected in the leakage current detection step (calculation step). Specifically, the calculator 15 calculates the combined Ior (i.e., the scalar sum: Ior(rt)) of Ior occurring in two phases (e.g., the R-phase and T-phase) by utilizing Equation (2) described above, Ior(r) occurring in the R-phase by utilizing Equation (3) described above, and Ior(t) occurring in the T-phase by utilizing Equation (4) described above.

In step ST6, the calculator 15 calculates a resistive component leakage current due to the ground insulation resistance included in the leakage current flowing through the line wire to be measured, based on the phase angle detected in the phase angle detection step and the leakage current detected in the leakage current detection step (calculation step). Specifically, the calculator 15 calculates the combined Ior (i.e., the scalar sum: Ior(ts)) of Ior occurring in two phases (e.g., the T-phase and S-phase) by utilizing Equation (5) described above, Ior(t) occurring in the T-phase by utilizing Equation (6) described above, and Ior(s) occurring in the S-phase by utilizing Equation (7) described above.

In step ST7, the calculator 15 calculates a resistive component leakage current due to the ground insulation resistance included in the leakage current flowing through the line wire to be measured, based on the phase angle detected in the phase angle detection step and the leakage current detected in the leakage current detection step (calculation step). Specifically, the calculator 15 calculates the combined Ior (i.e., the scalar sum: Ior(sr)) of Ior occurring in two phases (e.g., the S-phase and R-phase) by utilizing Equation (8) described above, Ior(s) occurring in the S-phase by utilizing Equation (9) described above, and Ior(r) occurring in the R-phase by utilizing Equation (10) described above.

In this manner, the inspection method enables accurate calculation of Ior occurring in R-phase and T-phase by utilizing Equations (2), (3), and (4) if the angle range of the phase angle belongs to the first angle range R1, accurate calculation of Ior occurring in T-phase and S-phase by utilizing Equations (5), (6), and (7) if the angle range of the phase angle belongs to the second angle range R2, and accurate calculation of Ior occurring in S-phase and R-phase by utilizing Equations (8), (9), and (10) if the angle range of the phase angle belongs to the third angle range R3. Based on these Ior calculated, it is possible to inspect or monitor the star-connected line wires to be measured.

(Inspection Program)

An inspection program that enables, in the event of the occurrence of Ior in one or both of two phases, accurate calculation of Ior occurring in each phase to inspect or monitor star-connected line wires to be measured includes the following as main steps and is executed by a computer 500 (hardware).

Step 1: Detecting a leakage current flowing through the line wires to be measured in which R-phase, S-phase, and T-phase are star-connected
Step 2: Detecting a voltage applied to the line wires to be measured
Step 3: Detecting a phase angle based on the leakage current detected in Step 1 and the voltage detected in Step 2
Step 4: Determining to which one of first, second, and third angle ranges R1, R2, and R3 the phase angle detected in Step 3 belongs, wherein R1 is an angle range between the first and second phases, R2 between the second and third phases, and R3 between the third and first phases
Step 5: Calculating a resistive component leakage current due to the ground insulation resistance included in the leakage current flowing through the line wire to be measured, based on the angle range determined in Step 4 where the phase angle belongs, the phase angle detected in Step 3, and the leakage current detected in Step 1

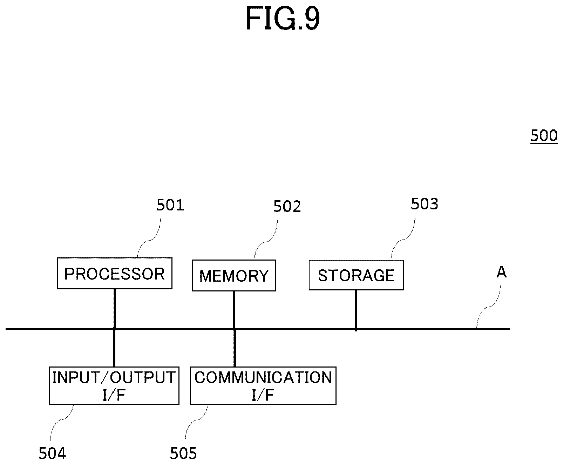

Here, a configuration and an operation of the computer 500 will be described with reference to the drawings. As shown in FIG. 9, the computer 500 is configured by connecting a processor 501, a memory 502, a storage 503, an input/output I/F 504, and a communication I/F 505 on a bus A. These components cooperate with each other to fulfill the functions and/or method described in the present disclosure.

For example, a display for displaying various types of information, a touch panel operated by a user, and other devices are connected to the input/output I/F 504. The touch panel is located at the front surface of the display. This configuration allows an intuitive operation of the user through a touch or any other suitable operation of icons on the display with a finger. The touch panel does not have to be located on the front surface of the display. Instead of or in addition to the touch panel, a keyboard or a pointing device, such as a mouse, may be connected to the input/output I/F 504. A speaker configured to output sound to the outside, or a microphone configured to receive external sound may be connected to the input/output I/F 504.

The display is a liquid crystal display, an organic electroluminescence (EL) display, or any other suitable display that displays various types of information under control by the processor 501.

The memory 502 is composed of a random-access memory (RAM). The RAM is composed of a volatile or non-volatile memory.

The storage 503 is composed of a read-only memory (ROM). The ROM is composed of a non-volatile memory and may be configured as, for example, a hard disk drive (HDD) or a solid-state drive (SSD). The storage 503 stores various types of programs, such as the inspection program executed in Steps 1 to 5 described above.

For example, the processor 501 controls the overall operation of the computer 500. The processor 501 is an arithmetic device that loads an operating system and various programs fulfilling various functions, from the storage 503 into the memory 502 and executes commands included in the loaded programs.

Specifically, upon input of operation by a user, the processor 501 reads out a program (e.g., the inspection program) stored in the storage 503, deploys the read program in the memory 502, and executes the program. Through the execution of the inspection program by the processor 501, the functions of the leakage current detector 11, the voltage detector 12, the phase angle detector 13, the determiner 14, and the calculator 15 are fulfilled.

Here, a configuration of the processor 501 will be described. The processor 501 is, for example, a central processing unit (CPU), a micro-processing unit (MPU), a graphics processing unit (GPU), any of other various arithmetic devices, or a combination thereof.

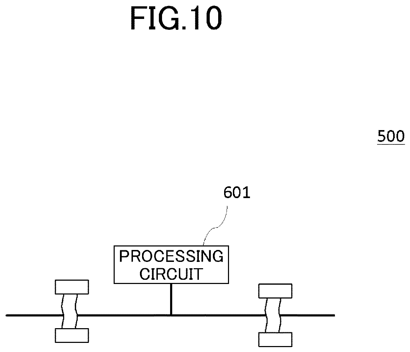

In order to fulfill the functions and/or method described in the present disclosure, a part or all of the functions of the processor 501, the memory 502, the storage 503, and other components may be configured by a processing circuit 601 which is dedicated hardware, as shown in FIG. 10. The processing circuit 601 is, for example, a single circuit, a composite circuit, a programmed processor, a parallel-programmed processor, an application specific integrated circuit (ASIC), a field-programmable gate array (FPGA), or a combination thereof.

While the processor 501 has been described as a single component, the configuration is not limited thereto. The processor 501 may be a group of a plurality of physically separate processors. In the present specification, a program or commands included in the program has/have been described as being executed by the processor 501. The program or commands may be executed by the single processor 501 or may be distributed to a plurality of processors for execution. The program or commands included in the program, which is/are executed by the processor 501, may be executed by a plurality of virtual processors.

The communication I/F 505 conforms to a predetermined communication protocol and establishes wired or wireless communication with an external device.

In this manner, the inspection program, when executed by the computer 500, enables accurate calculation of Ior occurring in R-phase and T-phase by utilizing Equations (2), (3), and (4) if the angle range of the phase angle belongs to the first angle range R1, accurate calculation of Ior occurring in T-phase and S-phase by utilizing Equations (5), (6), and (7) if the angle range of the phase angle belongs to the second angle range R2, and accurate calculation of Ior occurring in S-phase and R-phase by utilizing Equations (8), (9), and (10) if the angle range of the phase angle belongs to the third angle range R3. Based on these Ior calculated, it is possible to inspect or monitor the star-connected line wires to be measured.

DESCRIPTION OF REFERENCE CHARACTERS

1    Inspection Device
10    Zero-Phase Current Transformer
11    Leakage Current Detector
12    Voltage Detector
13    Phase Angle Detector
14    Determiner
15    Calculator

**Claims**

1. An inspection device comprising:

    a leakage current detector configured to detect a leakage current flowing through line wires to be measured in which a first phase, a second phase, and a third phase are star-connected or the first phase, the second phase, the third phase, and a neutral wire are star-connected;
    a voltage detector configured to detect a voltage applied to the line wires to be measured;
    a phase angle detector configured to detect a phase angle, based on the leakage current detected by the leakage current detector and the voltage detected by the voltage detector;
    a determiner configured to determine to which one of a first angle range, a second angle range, and a third angle range the phase angle detected by the phase angle detector belongs, the first angle range being an angle range between the first phase and the second phase, the second angle range being an angle range between the second phase and the third phase, the third angle range being an angle range between the third phase and the first phase; and
    a calculator configured to calculate a resistive component leakage current due to a ground insulation resistance included in the leakage current flowing through the line wires to be measured, based on the angle range to which the phase angle belongs, the phase angle detected by the phase angle detector, and the leakage current detected by the leakage current detector.

2. The inspection device of claim 1, wherein the calculator calculates:

    a combined value of the resistive component leakage currents flowing in the first phase and the second phase and the resistive component leakage current flowing in each of the first phase and the second phase, if the phase angle belongs to the first angle range;
    a combined value of the resistive component leakage currents flowing in the second phase and the third phase and the resistive component leakage current flowing in each of the second phase and the third phase, if the phase angle belongs to the second angle range; and
    a combined value of the resistive component leakage currents flowing in the first phase and the third phase and the resistive component leakage current flowing in each of the first phase and the third phase, if the phase angle belongs to the third angle range.

3. The inspection device of claim 1 or 2, wherein using a voltage of the first phase as a reference, the first angle range is an angle range of 120° between the first phase and the second phase, the second angle range is an angle range of 120° between the second phase and the third phase, and the third angle range is an angle range of 120° between the third phase and the first phase.

4. The inspection device of any one of claims 1 to 3, wherein

    the voltage detector detects
    a line voltage between any two of three non-ground wires,
    a voltage between each of any two phases and a ground wire or the neutral wire,
    a voltage between any one of the three non-ground wires and the ground wire or the neutral wire, or
    a voltage between each of all the three non-ground wires and the ground wire or the neutral wire, or between the ground wire and each of all the wires including the neutral wire.

5. An inspection method comprising:

    detecting a leakage current flowing through line wires to be measured in which a first phase, a second phase, and a third phase are star-connected or the first phase, the second phase, the third phase, and a neutral wire are star-connected;
    detecting a voltage applied to the line wires to be measured;

detecting a phase angle, based on the leakage current detected in the detecting the leakage current and the voltage detected in the detecting the voltage;

determining to which one of a first angle range, a second angle range, and a third angle range the phase angle detected in the detecting the phase angle belongs, the first angle range being an angle range between the first phase and the second phase, the second angle range being an angle range between the second phase and the third phase, the third angle range being an angle range between the third phase and the first phase; and

calculating a resistive component leakage current due to a ground insulation resistance included in the leakage current flowing through the line wires to be measured, based on the angle range to which the phase angle belongs, the phase angle detected in the detecting the phase angle, and the leakage current detected in detecting the leakage current.

6. An inspection program for causing a computer to execute:

detecting a leakage current flowing through line wires to be measured in which a first phase, a second phase, and a third phase are star-connected or the first phase, the second phase, the third phase, and a neutral wire are star-connected;

detecting a voltage applied to the line wires to be measured;

detecting a phase angle, based on the leakage current detected in the detecting the leakage current and the voltage detected in the detecting the voltage;

determining to which one of a first angle range, a second angle range, and a third angle range the phase angle detected in detecting the phase angle belongs, the first angle range being an angle range between the first phase and the second phase, the second angle range being an angle range between the second phase and the third phase, the third angle range being an angle range between the third phase and the first phase; and

calculating a resistive component leakage current due to a ground insulation resistance included in the leakage current flowing through the line wires to be measured, based on the angle range to which the phase angle belongs, the phase angle detected in the detecting the phase angle, and the leakage current detected in the detecting the leakage current.

# FIG.1

N

R

S

T

10

10

1

**LEAKAGE CURRENT DETECTOR** 11

**VOLTAGE DETECTOR** 12

**PHASE ANGLE DETECTOR** 13

**DETERMINER** 14

**CALCULATOR** 15

# FIG.2

# FIG.3

# FIG.4

# FIG.5

# FIG.6

# FIG.7

T-PHASE

R-PHASE

Ior(r)

θ

X($V_{T-R}$)

Io

Ior(s)

Ior(r)'

R3

S-PHASE

# FIG.8

START

DETECT LEAKAGE CURRENT Io FLOWING
THROUGH LINE WIRES TO BE MEASURED — ST1

DETECT VOLTAGE APPLIED TO
LINE WIRES TO BE MEASURED — ST2

DETECT PHASE ANGLE BASED ON
LEAKAGE CURRENT Io AND VOLTAGE — ST3

DETERMINE TO WHICH ONE OF FIRST,
SECOND, AND THIRD ANGLE RANGES
R1, R2, AND R3 PHASE ANGLE BELONGS — ST4

R1

R3

R2 — ST6

ST5

ST7

CALCULATE COMBINED Ior
OF Ior GENERATED IN
R-PHASE AND T-PHASE, Ior(r)
GENERATED IN R-PHASE,
AND Ior(t) GENERATED IN
T-PHASE

CALCULATE COMBINED Ior
OF Ior GENERATED IN
T-PHASE AND S-PHASE, Ior(t)
GENERATED IN T-PHASE,
AND Ior(s) GENERATED IN
S-PHASE

CALCULATE COMBINED Ior
OF Ior GENERATED IN
S-PHASE AND R-PHASE, Ior(s)
GENERATED IN S-PHASE,
AND Ior(r) GENERATED IN
R-PHASE

END

# FIG.9

500

501      502      503

| PROCESSOR | MEMORY | STORAGE | A |

| INPUT/OUTPUT I/F | COMMUNICATION I/F |

504      505

# FIG.10

500

601

PROCESSING
CIRCUIT

## INTERNATIONAL SEARCH REPORT

| International application No. |
| --- |
| **PCT/JP2021/045001** |

### A. CLASSIFICATION OF SUBJECT MATTER

*G01R 31/52*(2020.01)i; *G01R 31/58*(2020.01)i
FI: G01R31/58; G01R31/52

According to International Patent Classification (IPC) or to both national classification and IPC

### B. FIELDS SEARCHED

Minimum documentation searched (classification system followed by classification symbols)

G01R31/52; G01R31/58

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | WO 2018/167909 A1 (KASHIRAMOTO, Yorikazu) 20 September 2018 (2018-09-20) paragraphs [0014]-[0054], fig. 1-6 | 1-6 |
| A | JP 2015-64265 A (KANTO DENKI KOJI) 09 April 2015 (2015-04-09) entire text, all drawings | 1-6 |
| A | JP 2018-155535 A (SATORI ELECTRIC CO LTD) 04 October 2018 (2018-10-04) entire text, all drawings | 1-6 |
| A | WO 2018/221619 A1 (CDN CORP) 06 December 2018 (2018-12-06) entire text, all drawings | 1-6 |
| A | US 2015/0212139 A1 (GF TECHNOLOGIES, LLC) 30 July 2015 (2015-07-30) entire text, all drawings | 1-6 |

☐ Further documents are listed in the continuation of Box C.    ☑ See patent family annex.

| | |
| --- | --- |
| * Special categories of cited documents: <br> "A" document defining the general state of the art which is not considered to be of particular relevance <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |
| Date of the actual completion of the international search <br><br> **18 January 2022** | Date of mailing of the international search report <br><br> **01 February 2022** |
| Name and mailing address of the ISA/JP <br><br> **Japan Patent Office (ISA/JP)** <br> **3-4-3 Kasumigaseki, Chiyoda-ku, Tokyo 100-8915** <br> **Japan** | Authorized officer <br><br><br> Telephone No. |

Form PCT/ISA/210 (second sheet) (January 2015)

<table>
<tr><td colspan="2" align="center">**INTERNATIONAL SEARCH REPORT**<br>**Information on patent family members**</td><td colspan="2">International application No.<br><br>**PCT/JP2021/045001**</td></tr>
<tr><td align="center">Patent document<br>cited in search report</td><td align="center">Publication date<br>(day/month/year)</td><td align="center">Patent family member(s)</td><td align="center">Publication date<br>(day/month/year)</td></tr>
<tr><td>WO   2018/167909  A1</td><td>20 September 2018</td><td>EP      3598153   A1<br>paragraphs [0014]-[0057], fig.<br>1-6<br>CN     110402396   A<br>KR  10-2019-0127807   A</td><td></td></tr>
<tr><td>JP   2015-64265  A</td><td>09 April 2015</td><td>(Family: none)</td><td></td></tr>
<tr><td>JP   2018-155535  A</td><td>04 October 2018</td><td>(Family: none)</td><td></td></tr>
<tr><td>WO   2018/221619  A1</td><td>06 December 2018</td><td>(Family: none)</td><td></td></tr>
<tr><td>US   2015/0212139  A1</td><td>30 July 2015</td><td>WO   2015/112572  A2<br>entire text, all drawings<br>CA     2937814   A1</td><td></td></tr>
</table>

Form PCT/ISA/210 (patent family annex) (January 2015)

**EP 4 249 932 A1**

**REFERENCES CITED IN THE DESCRIPTION**

**Patent documents cited in the description**

- JP 2011027449 A